# EUROPEAN PATENT APPLICATION

(11) **EP 2 784 818 A2**
(43) Date of publication of application: **01.10.2014**
(21) Application number: 14161890.0
(22) Date of filing: 27.03.2014
(51) Int. Cl.: H01L 27/112, H01L 27/06, H01L 27/07

(54) **Nonvolatile memory cell structure and method for programming and reading the same**

(30) Priority: 28.03.2013 US 201361806393 P
(71) Applicant: eMemory Technology Inc., Hsin-Chu 30075 (TW)
(72) Inventor: Wu, Meng-Yi, 302 Hsinchu County (TW); Huang, Chih-Hao, 302 Hsinchu County (TW); Wen, Yueh-Chia, 325 Taoyuan County (TW); Chen, Chin-Yi, 234 New Taipei City (TW); Chen, Lun-Chun, 265 Yilan County (TW); Chen, Hsin-Ming, 300 Hsinchu City (TW)
(74) Representative: Becker Kurig Straus

(57) **Abstract**

A nonvolatile memory cell structure (102, 103, 104) includes a substrate (110) of a first conductivity, a first doping well (121) of a second conductivity disposed in said substrate (110), a second doping well (131) of said first conductivity disposed in said substrate (110), an antifuse gate (160) disposed on said first doping well (121), and a drain doping region (151) away from said antifuse gate (160). The antifuse gate (160) includes a gate conductive layer (161) disposed on said first doping well (121) and a gate oxide layer (162) disposed between said gate conductive layer (161) and said first doping well (121) and directly contacting said first doping well (121) . A current path (129) from said antifuse gate (160) to said drain doping region (151) travels through said first doping well (121) and said second doping well (131).

## Description

### Field of the Invention

The present invention generally relates to a nonvolatile memory cell structure and the method for programming and reading the nonvolatile memory cell structure. In particular, the present invention is directed to a nonvolatile memory cell structure of an antifuse type and the method for programming and reading the nonvolatile memory cell structure of an antifuse type according to the claims here below.

### Background of the Invention

Memory devices may be divided into volatile memory devices and nonvolatile memory devices. In the nonvolatile memory devices, storing data can persist even when power is turned off. This persistent characteristic makes the nonvolatile memory devices useful for data storage in applications such as mobile phones, digital cameras, video players, or personal digital assistants (PDA).

In the current one-time program memory (OTP) technology, there may be some possible bottlenecks. For example, an ultra high voltage device such as 13.5V or 20V is needed to achieve programming or reading. Multiple voltage devices such as ultra high voltage, medium voltage or low voltage are needed to achieve programming or reading. When the programming voltage is greater than 10V, there may be a junction breakdown for the N+/p well junction. In the programming mode, an ultra high voltage such as 13.5V or more is needed. However, such high voltage drastically increases the risk of the oxide breakdown of a select transistor.

In view of the middle voltage (MV) device (3.3V or 5V) not available for the cost or structure consideration in the current platform, a nonvolatile memory cell structure is needed to adjust the performance requirements of the nonvolatile memory cell structure to achieve a simpler structure and more flexible operational requirements.

### Summary of the Invention

The present invention aims at providing a nonvolatile memory cell structure of an antifuse type and the method for programming and reading the nonvolatile memory cell structure, wherein the nonvolatile memory cell structure has very flexible structural layouts to meet the demands of different operational requirements. In addition, a medium voltage (3.3V or 5V) is not needed in the programming or reading step to be compatible with the current platform.

This is achieved by a nonvolatile memory cell structure and the method for programming and reading the nonvolatile memory cell structure according to the claims here below. The dependent claims pertain to corresponding further developments and improvements.

As will be seen more clearly from the detailed description following below, the present invention in a first aspect provides a nonvolatile memory cell structure with no select gate. The nonvolatile memory cell structure includes a substrate, a first doping well, a second doping well, an antifuse gate and a drain doping region. The substrate has a first conductivity. The first doping well has a second conductivity and is disposed in the substrate. The second doping well has the first conductivity and is disposed in the substrate. The antifuse gate is disposed on the first doping well and includes a gate conductive layer and a gate oxide layer. The gate conductive layer is disposed on the first doping well and the gate oxide layer is disposed between the gate conductive layer and the first doping well, directly contacts the first doping well and is thin enough to be ruptured. The drain doping region is disposed away from the antifuse gate. A current path from the antifuse gate to the drain doping region travels through the first doping well and the second doping well.

In one embodiment of the present invention, the first doping well is in direct contact with the second doping well.

In another embodiment of the present invention, the first doping well is segregated from the second doping well by a predetermined length and the current path further travels through the substrate.

In another embodiment of the present invention, the drain doping region is disposed inside the second doping well.

In another embodiment of the present invention, the antifuse gate serves as a capacitor before programming and serves as a resistor after optional programming.

In one embodiment of the present invention, a shallow trench isolation is further disposed inside the first doping well as well as between the antifuse gate and the second doping well so that a current path further travels around the shallow trench isolation.

In further embodiment of the present invention, the nonvolatile memory cell structure further includes a select gate disposed on both the first doping well and the second doping well to control the activation of the nonvolatile memory cell structure.

In another embodiment of the present invention, the nonvolatile memory cell structure further includes a select gate disposed on said second doping well, a first drain doping region disposed inside the second doping well, a second drain doping region, a third drain doping region, and a metal routing. The second drain doping region is disposed inside the second doping well and adjacent to the select gate. The third drain doping region is disposed inside the first doping well and adjacent to the antifuse gate so that the shallow trench isolation is disposed between the second drain doping region and the third drain doping region. The metal routing electrically connects the second drain doping region and the third drain doping region.

In another embodiment of the present invention, the shallow trench isolation has an adjustable trench depth.

As will be seen more clearly from the detailed description following below, the present invention in a second aspect provides a symmetric nonvolatile memory cell structure. The symmetric nonvolatile memory cell structure includes a substrate, a doping well, a symmetric shallow trench isolation set (wherein the trench isolations set are symmetrically disposed), drain doping regions (wherein the drain doping regions are symmetrically disposed), and an antifuse gate. The substrate has a conductivity. The doping well is disposed in the substrate. The symmetric shallow trench isolation set includes a left part and a right part and they are symmetrically disposed inside the doping well. The symmetric drain doping regions includes a left drain doping region and a right drain doping region and they both are disposed inside the doping well. The left drain doping region is disposed adjacent to the left part. The right drain doping region is disposed adjacent to the right part. The antifuse gate is disposed on the doping well and between the symmetric shallow trench isolation set. The antifuse gate includes a gate conductive layer and a gate oxide layer. The gate conductive layer is disposed on the doping well. The gate oxide layer is disposed between the gate conductive layer and the doping well, directly contacts the doping well and is thin enough to be ruptured.

In one embodiment of the present invention, the doping well has a conductivity different from the conductivity of the substrate.

In another embodiment of the present invention, the symmetric nonvolatile memory cell comprises a further doping well. The further doping well has a conductivity different from the conductivity of the substrate and entirely surrounds the doping well so that the further doping well is disposed between the substrate and the doping well. The conductivity of the doping well is different from the conductivity of the further conductivity.

As will be seen more clearly from the detailed description following below, the present invention in a third aspect provides a nonvolatile memory cell structure. The nonvolatile memory cell structure includes a substrate of a first conductivity, a doping well of a second conductivity disposed in the substrate, a drain doping region, a shallow trench isolation and an antifuse gate. The antifuse gate is disposed on the doping well and includes a gate conductive layer and a gate oxide layer. The gate conductive layer is disposed on the doping well. The gate oxide layer is disposed between the gate conductive layer and the doping well as well as directly contacts the doping well. The drain doping region is disposed inside the doping well and away from the antifuse gate. The shallow trench isolation is disposed between the drain doping region and the antifuse gate. A current path from the antifuse gate to the drain doping region travels through around the shallow trench isolation. In one embodiment of the present invention, the shallow trench isolation has an adjustable trench depth.

As will be seen more clearly from the detailed description following below, the present invention in a fourth aspect provides a method for reading a nonvolatile memory cell. First, at least one nonvolatile memory cell as presented above is provided. The nonvolatile memory cell structure includes a substrate, a first doping well, a second doping well, an antifuse gate and a drain doping region. The substrate has a first conductivity. The first doping well has a second conductivity and is disposed in the substrate. The second doping well has the first conductivity and is disposed in the substrate. The antifuse gate is disposed on the first doping well and includes a gate conductive layer and a gate oxide layer. The gate conductive layer is disposed on the first doping well and the gate oxide layer is disposed between the gate conductive layer and the first doping well, directly contacts the first doping well and is thin enough to be ruptured. The drain doping region is disposed away from the antifuse gate. A current path from the antifuse gate to the drain doping region travels through the first doping well and the second doping well. The antifuse gate is electrically connected to an antifuse line and the drain doping region is electrically connected to a bit line. Next, the antifuse line is grounded and the bit line is provided with a reading voltage to read the nonvolatile memory cell.

As will be seen more clearly from the detailed description following below, the present invention in a fifth aspect provides a method for reading a nonvolatile memory cell. First, at least one nonvolatile memory cell as presented above is provided. The nonvolatile memory cell structure includes a substrate, a doping well, a symmetric shallow trench isolation set, symmetric drain doping regions, and an antifuse gate. The substrate has a type of conductivity. The doping well is disposed in the substrate. The symmetric shallow trench isolation set includes a left part and a right part and they both are disposed inside the doping well. The symmetric drain doping regions includes a left drain doping region and a right drain doping region and they both are disposed inside the doping well. The left drain doping region is disposed adjacent to the left part. The right drain doping region is disposed adjacent to the right part. The antifuse gate is disposed on the doping well and between the symmetric shallow trench isolation set. The antifuse gate includes a gate conductive layer and a gate oxide layer. The gate conductive layer is disposed on the doping well. The gate oxide layer is disposed between the gate conductive layer and the doping well, directly contacts the doping well and is thin enough to be ruptured. The antifuse gate is electrically connected to an antifuse line and the drain doping region is electrically connected to a bit line. Then, the antifuse line is grounded and a bit line with a reading voltage is provided to read the nonvolatile memory cell.

As will be seen more clearly from the detailed description following below, the present invention in a sixth aspect provides a method for reading a nonvolatile memory cell. First, at least one nonvolatile memory cell as presented above is provided. The nonvolatile memory cell structure includes a substrate of a first conductivity, a doping well of a second conductivity disposed in the substrate, a drain doping region, a shallow trench isolation and an antifuse gate. The antifuse gate is disposed on the doping well and includes a gate conductive layer and a gate oxide layer. The gate conductive layer is disposed on the doping well. The gate oxide layer is disposed between the gate conductive layer and the doping well as well as directly contacts the doping well. The drain doping region is disposed inside the doping well and away from the antifuse gate. The shallow trench isolation is disposed between the drain doping region and the antifuse gate. A current path from the antifuse gate to the drain doping region travels through around the shallow trench isolation. The antifuse gate is electrically connected to an antifuse line and the drain doping region is electrically connected to a bit line. Then, the antifuse line is grounded and a bit line with a reading voltage is provided to read the nonvolatile memory cell.

The programming voltage is used to program a nonvolatile memory cell. In this invention, a suitable programming voltage is capable of converting the capacitor to be a resistor. One feature of the nonvolatile memory cell structure of the present invention resides in that the programming voltage used to program the nonvolatile memory cell structure is adjustable. For example, the programming voltage may be as low as 10V rather than a higher one, such as 13.5V - 20V.When programming the nonvolatile memory cell structure, the current travels from the antifuse gate to the left drain doping region and/or the right drain doping region. The resistance along the current path determines the programming voltage used to program the nonvolatile memory cell structure. Accordingly, the nonvolatile memory cell structure of the present invention may have multiple ways to adjust the programming voltage. Further, the thickness of the gate oxide layer may be optimized so that it is thin enough to be easily ruptured by a predetermined programming voltage to meet the requirements of the One-time program memory (OTP) technology in one embodiment. In another embodiment of the present invention, the adjustable trench depth is also optimized to obtain an optimal programming voltage for practice. Accordingly, a novel nonvolatile memory cell structure is provided by the present invention. This novel nonvolatile memory cell structure has adjustable current path so that the programming voltage and reading voltage for use in novel nonvolatile memory cell structure can be simplified to be high voltage or low voltage only without the need for a middle voltage.

### Brief Description of the Drawings

In the following, the invention is further illustrated by way of example, taking reference to the accompanying drawings. Thereof
FIG. 1 and FIG. 2 illustrate two examples of the nonvolatile memory cell of symmetric structure of the present invention,
FIG. 3 to FIG. 6 illustrate examples of the nonvolatile memory cell structure of the present invention,
FIG. 7 to FIG. 10 illustrate examples of the nonvolatile memory cell structure of the present invention,
FIG. 11 to FIG. 15 illustrate examples of the nonvolatile memory cell structure of the present invention,
FIG. 16 to FIG. 19 illustrate a method for programming a nonvolatile memory cell of the present invention, and

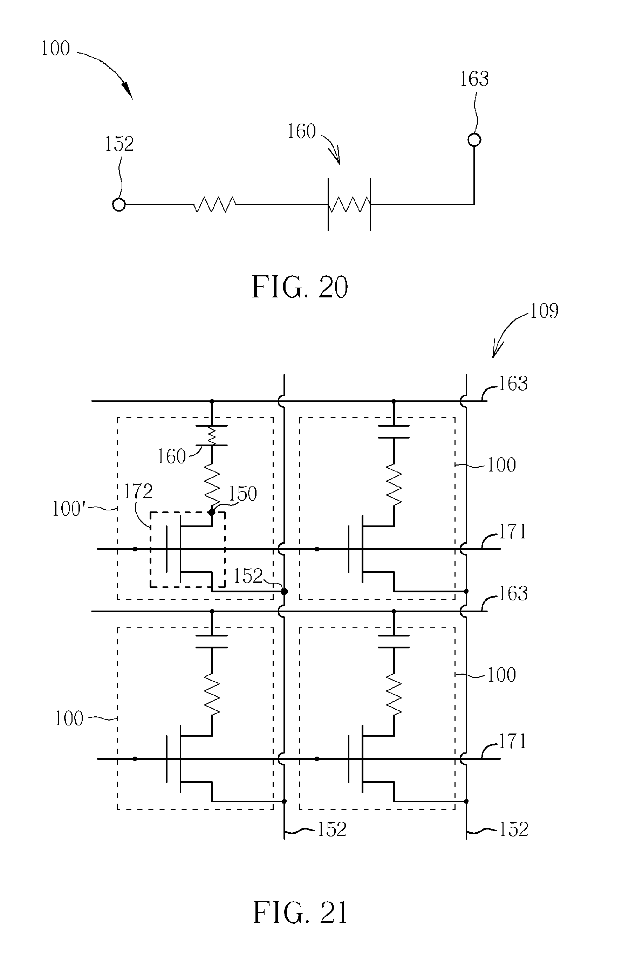

FIG. 20 to FIG. 23 illustrate a method for reading a nonvolatile memory cell of the present invention.

### Detailed Description

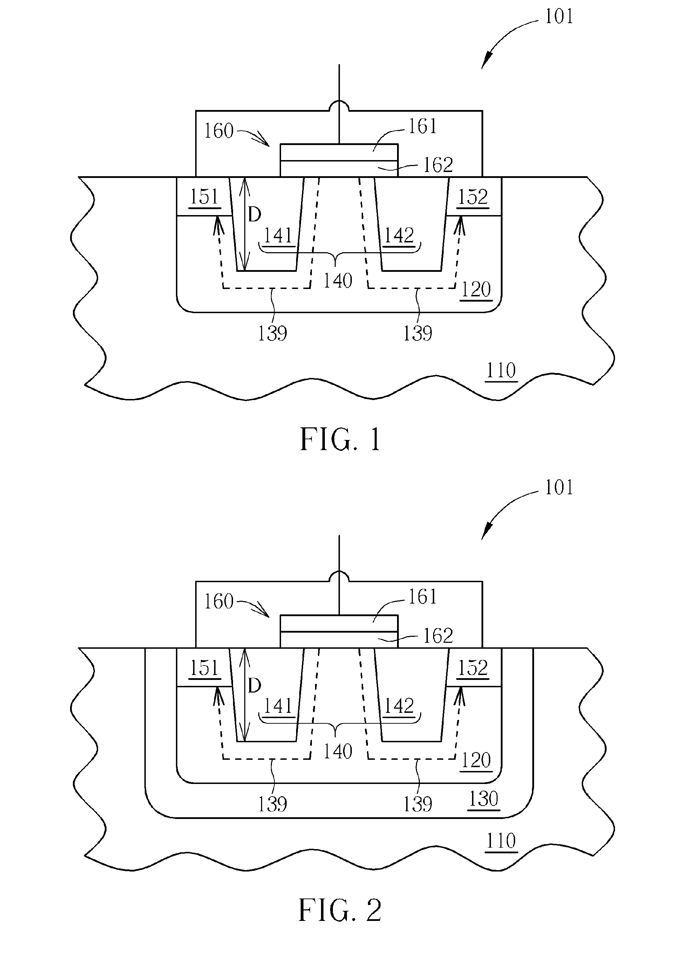

The novel nonvolatile memory cell structure of the present invention may have many structural variations due to optional elements. FIG. 1 to FIG. 15 illustrate various examples of the nonvolatile memory cell structures of the present invention. First, please refer to FIG. 1 or FIG. 2, wherein two examples of the nonvolatile memory cell of a symmetric structure are illustrated. The nonvolatile memory cell structure 101of the present invention may include a substrate 110, a first doping well 120, an optional second doping well 130, a shallow trench isolation set, drain doping regions 151/152, and an antifuse gate 160. The substrate 110 may be a semiconductive material, such as silicon (Si). In addition, the substrate 110 may have a first conductivity, such as N type or P type, preferably P type.

There is a first doping well 120 disposed in the substrate 110. It is also possible that there may be an optional second doping well 130 which entirely surrounds the first doping well 120. The first doping well 120 defines a region for the path 139 which the current travels from the antifuse gate 160 to drain doping regions 151/152. If the second doping well 130 is absent, as shown in FIG. 1, the first doping well 120 is in direct contact with the substrate 110 and has a second conductivity, such as N type or P type, different from that of the first conductivity.

Alternatively, if the second doping well 130 is present, as shown in FIG. 2, the second doping well 130 is in direct contact with the substrate 110 and has a second conductivity, such as N type or P type, different from that of the first conductivity. In other words, the second doping well 130 is disposed between the substrate 110 and the first doping well 120 which has the first conductivity different from that of the second conductivity.

The shallow trench isolation 140 may be a symmetric shallow trench isolation set. For example, the symmetric shallow trench isolation set may include a left part 141 and a right part 142. The left part 141 and a right part 142 both are disposed inside the first doping well 120. In particular, the shallow trench isolation 140 may have an optionally adjustable trench depth D. For example, the trench depth D may be 3000Å - 4000Å.

There are also drain doping regions disposed inside the first doping well 120. The drain doping regions may be symmetric and have the conductivity like the first doping well 120. For example, the symmetric drain doping regions may include a left drain doping region 151 and a right drain doping region 152. The left drain doping region 151 is disposed adjacent to the left part 141. The right drain doping region 152 is disposed adjacent to the right part 142.

If the second doping well 130 is absent, as shown in FIG. 1, the left drain doping region 151 is disposed between the left part 141 and the substrate 110. The right drain doping region 152 is disposed between the right part 142 and the substrate 110. Alternatively, if the second doping well 130 is present, as shown in FIG. 2, the left drain doping region 151 is disposed between the left part 141 and the second doping well 130. The right drain doping region 152 is disposed between the right part 142 and the second doping well 130. The first doping well 120 inside the second doping well 130 enables a structure which improves the drain breakdown voltage (BVD).

The left drain doping region 151 and the right drain doping region 152 are respectively in direct contact with the second doping well 130 or the substrate 110. Further, the left drain doping region 151 and the right drain doping region 152 are respectively in direct contact with the left part 141or the right part 142.

The antifuse gate 160 is in one aspect disposed on the first doping well 120 and in another aspect disposed between the shallow trench isolation set, namely 141/142. Generally, the antifuse gate 160 includes a gate conductive layer 161 and a gate oxide layer 162.

The gate conductive layer 161 is disposed on the first doping well 120 and directly on the gate oxide layer 162. The gate conductive layer 161 may be an N+ poly gate or a P+ poly gate. The gate oxide layer162 is sandwiched between the gate conductive layer 161 and the first doping well 120. In other words, the gate oxide layer162 is in direct contact with the first doping well 120. Before programming, the gate conductive layer 161, the gate oxide layer 162and the first doping well 120 together serve as a capacitor. After programming, the gate conductive layer 161, the gate oxide layer 162and the first doping well 120 together serve as a resistor. Preferably, the gate oxide layer 162 is thin enough to be easily ruptured by a predetermined programming voltage.

The programming voltage is used to program a nonvolatile memory cell. In this invention, a suitable programming voltage is capable of converting the capacitor to be a resistor. One feature of the nonvolatile memory cell structure 101of the present invention resides in that the programming voltage used to program the nonvolatile memory cell structure 101 is adjustable. For example, the programming voltage may be as low as 10V rather than a higher one, such as 13.5V - 20V.

When programming the nonvolatile memory cell structure 101, the current travels from the antifuse gate 160to the left drain doping region 151 and/or the right drain doping region 152. The path 139 which the current takes is a current path. The resistance along the path 139 determines the programming voltage used to program the nonvolatile memory cell structure 101. Accordingly, the nonvolatile memory cell structure 101of the present invention may have multiple ways to adjust the programming voltage. In one embodiment of the present invention, the thickness of the gate oxide layer 162 is optimized so that it is thin enough to be easily ruptured by a predetermined programming voltage to meet the requirements of the One-time program memory (OTP) technology. In another embodiment of the present invention, the adjustable trench depth D is also optimized to obtain an optimal programming voltage for practice.

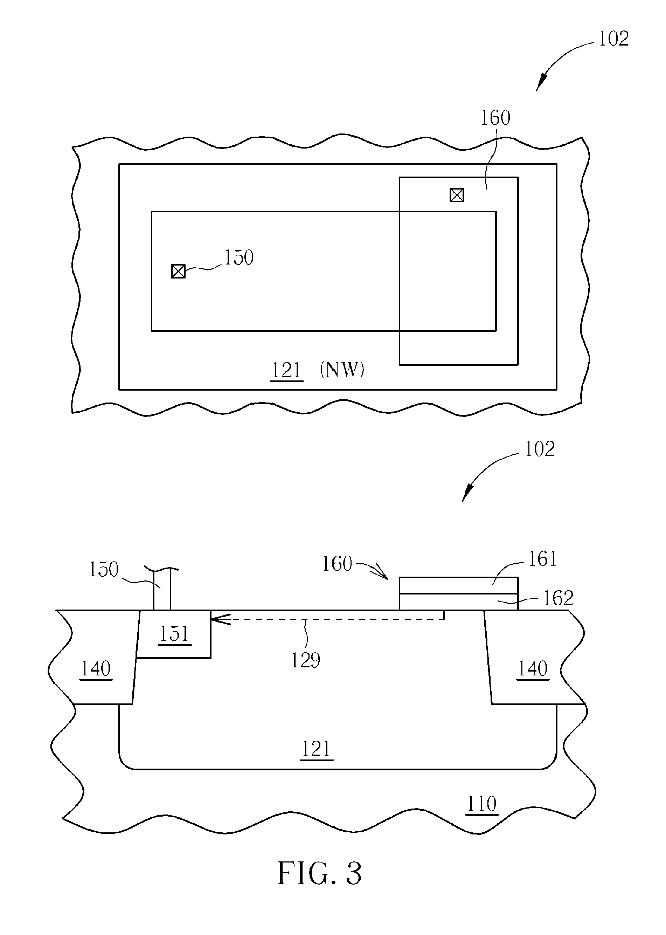

Second, please refer to FIG. 3, FIG. 4, FIG. 5, FIG. 6, which illustrate examples of one nonvolatile memory cell structure. The nonvolatile memory cell structure 102of the present invention includes a substrate 110, a first doping well 121, an optional doping well, a contact 150, a drain doping region 151 and an antifuse gate 160. The substrate 110 may be a semiconductive material, such as Si. In addition, the substrate 110 may have a first conductivity, such as N type or P type, preferably P type.

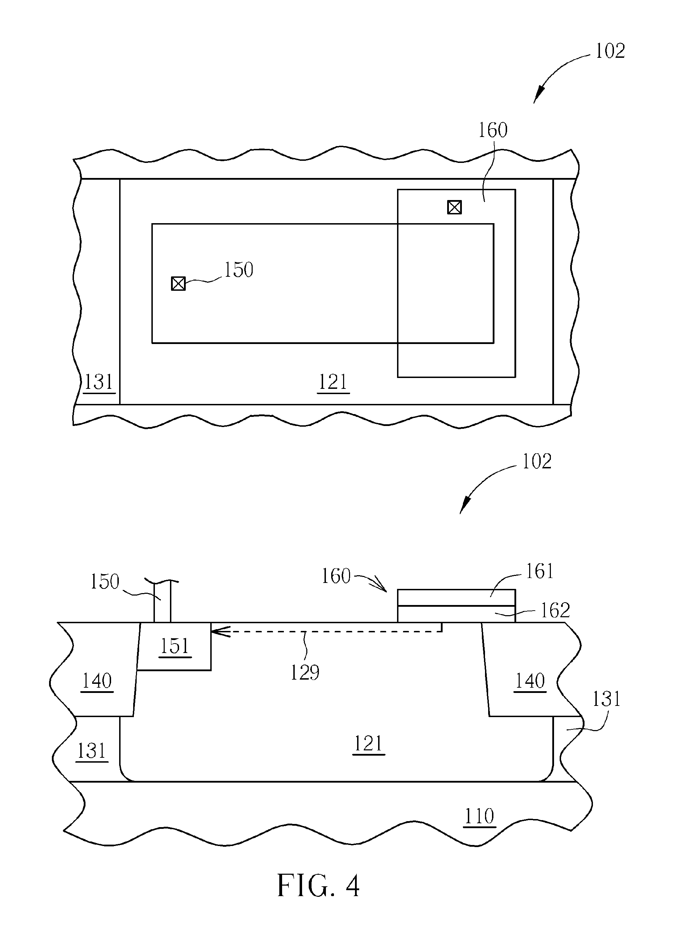

As shown in FIG. 3, there is at least one doping well, namely the first doping well 121, disposed in the substrate 110 to define the path 129 which the electric current takes. The first doping well 121 has a second conductivity different from that of the substrate 110. There may be another optional doping well disposed in the substrate 110 and adjacent to the first doping well 121. For example, if the optional doping well is absent, the first doping well 121 may be surrounded by the substrate 110. Alternatively, as shown in FIG. 4, if the optional doping well is present, the optional doping well is a second doping well 131 which has the conductivity different from that of the first doping well 121.

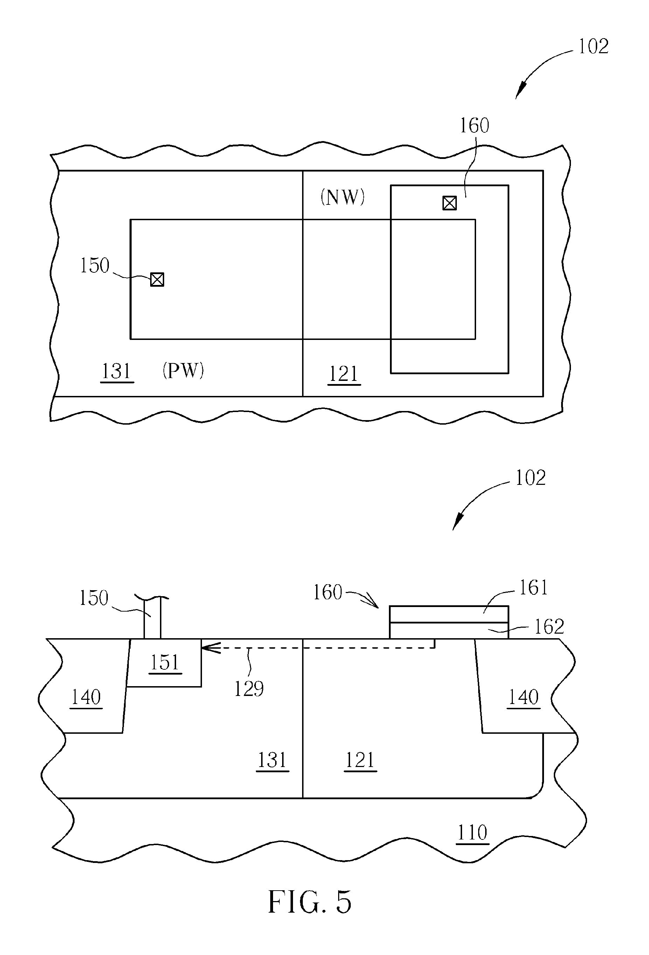

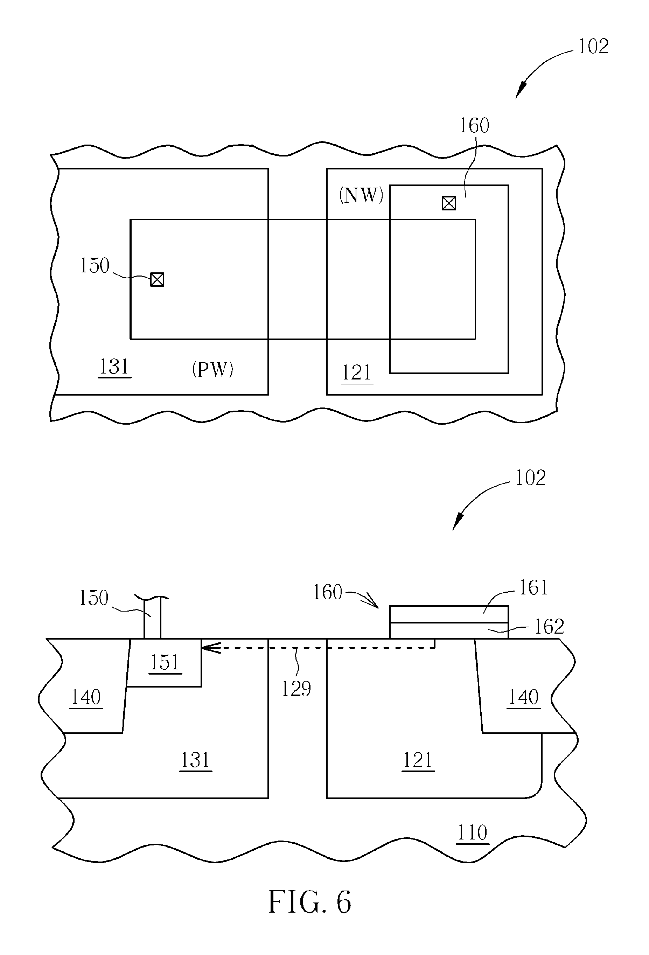

In another embodiment of the present invention, as shown in FIG. 5, the second doping well 131 and the first doping well 121 are in direct contact with each other to form the path 129 which the electric current takes. In still another embodiment of the present invention, as shown in FIG. 6, the second doping well 131 and the first doping well 121 are segregated by the substrate 110 and not in direct contact with each other so the second doping well 131, the first doping well 121 and the substrate 110 together form the path 129 which the electric current takes.

The antifuse gate 160 is disposed on the first doping well 121 and includes a gate conductive layer 161 and a gate oxide layer 162. The gate conductive layer 161 is disposed on the gate oxide layer 162 and on the first doping well 121. The gate oxide layer 162is disposed between the gate conductive layer 161 and the first doping well 121. In other words, the gate oxide layer162 is in direct contact with the first doping well 121. Before programming, the gate conductive layer 161, the gate oxide layer 162and the first doping well 121 together serve as a capacitor. After programming, the gate oxide layer 162is intentionally ruptured so the gate conductive layer 161, the gate oxide layer 162and the first doping well 121 together serve as a resistor. Preferably, the gate oxide layer 162 is thin enough to be easily ruptured by a predetermined programming voltage.

The contact 150 stays away from the antifuse gate 160. In one embodiment of the present invention, there may be a drain doping region 151, disposed either in the first doping well 121 or in the second doping well 131, and staying away from the antifuse gate 160 as shown in FIG. 4 or in FIG. 5. The drain doping region 151 may have the same conductivity as the first doping well 121. The current path 129 from the antifuse gate 160 to the drain doping region 151 travels through the first doping well 121, or further through the second doping well 131, or further through the substrate 110.

One feature of the nonvolatile memory cell structure 102of the present invention resides in that there is only one gate, namely the antifuse gate 160, in the nonvolatile memory cell structure 101. There is no other gate, such as a select gate in the nonvolatile memory cell structure 102. Another feature of the nonvolatile memory cell structure 102of the present invention resides in that there is no shallow trench isolation disposed inside the first doping well 121 or inside the second doping well 131 to block the path 129. The shallow trench isolation merely surrounds the first doping well 121or the optional the second doping well 131 without disposing inside the first doping well 121.

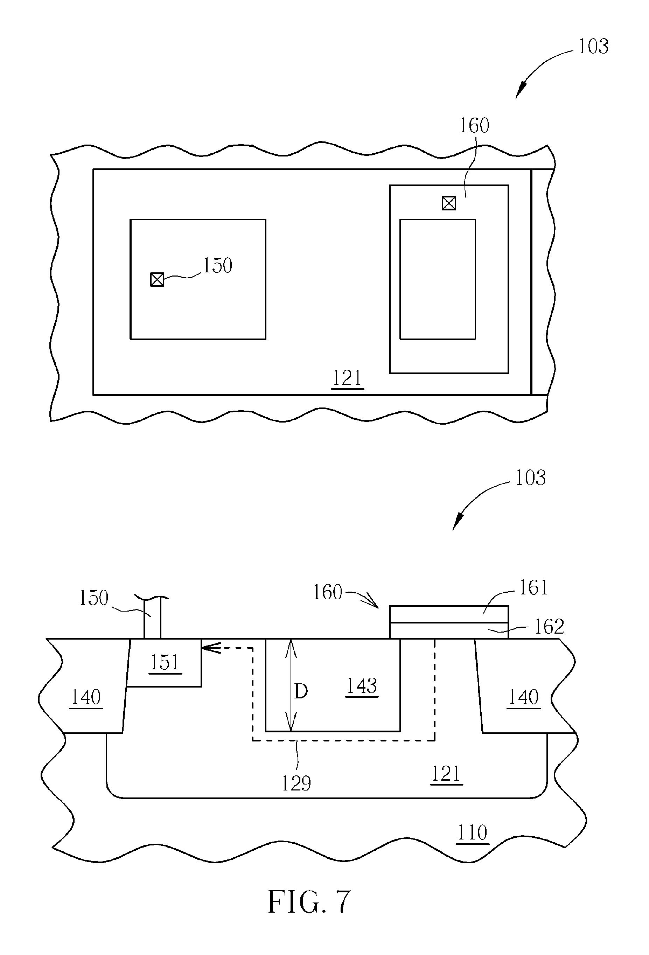

Third, please refer to FIG. 7, FIG. 8, FIG. 9, FIG. 10, which illustrate examples of another nonvolatile memory cell structure. The nonvolatile memory cell structure 103of the present invention includes a substrate 110, a first doping well 121, an optional second doping well 131, a shallow trench isolation 140, a contact 150, a drain doping region 151 and an antifuse gate 160. The substrate 110 may be a semiconductive material, such as Si. In addition, the substrate 110 may have a first conductivity, such as N type or P type, preferably P type. The shallow trench isolation 140 surrounds the first doping well 121or the optional second doping well 131. There is another shallow trench isolation 143 which is disposed inside the first doping well 121 as well as between the antifuse gate 160 and the contact 150, or the drain doping region 151 or the second doping well 131.

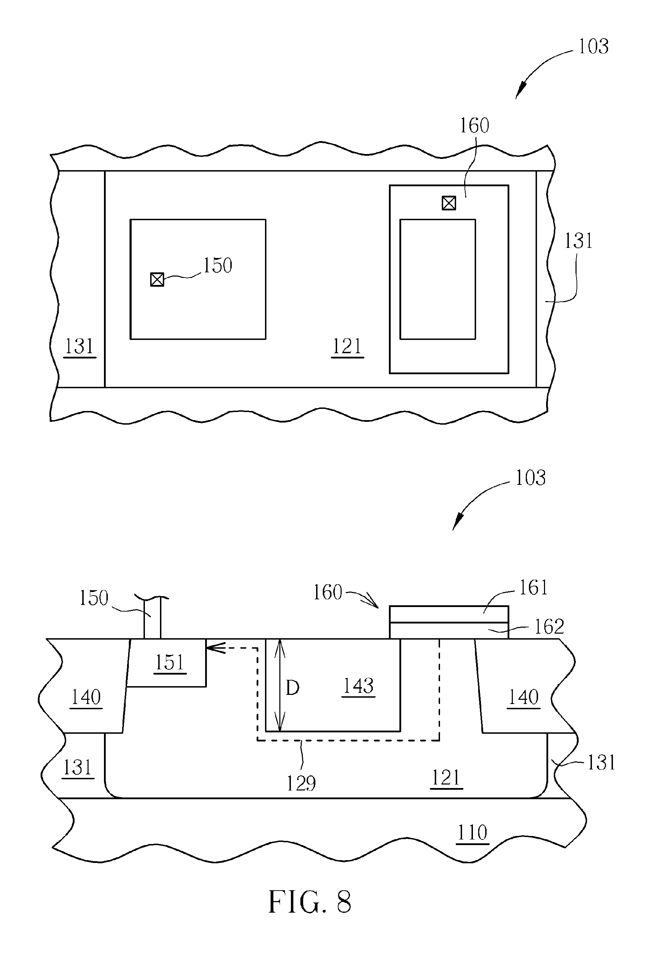

As shown in FIG. 7, there is at least one doping well, namely the first doping well 121, disposed in the substrate 110. The first doping well 121 has a second conductivity different from that of the substrate 110. There may be an optional doping well disposed in the substrate 110 and adjacent to the first doping well 121. For example, if the optional doping well is absent, the first doping well 121 is surrounded by the substrate 110. Alternatively, as shown in FIG. 8, if the optional doping well is present, the optional doping well is a second doping well 131 which has the conductivity different from that of the first doping well 121 and is disposed next to the first doping well 121.

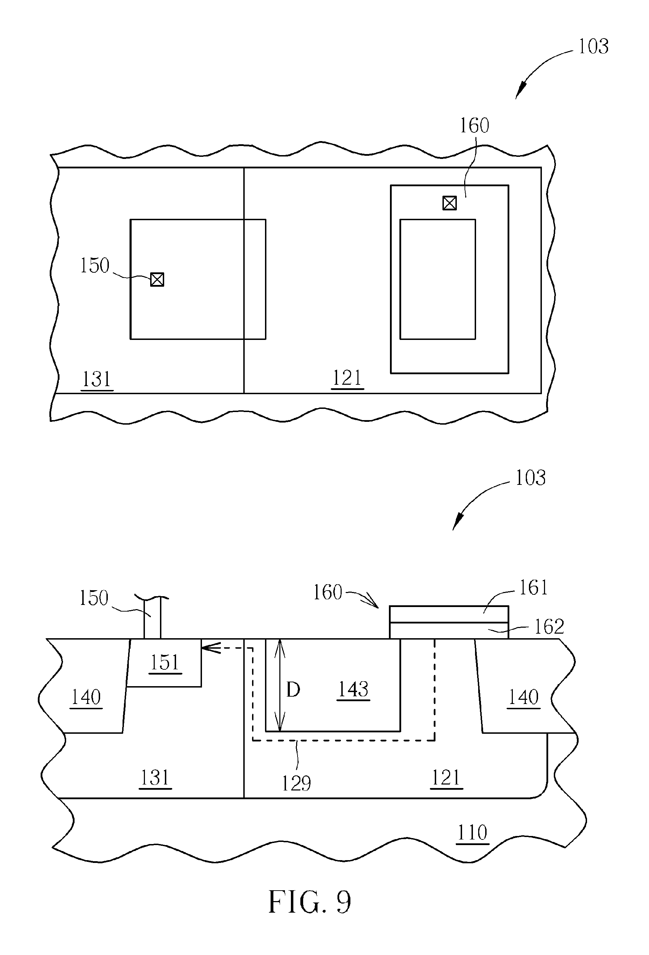

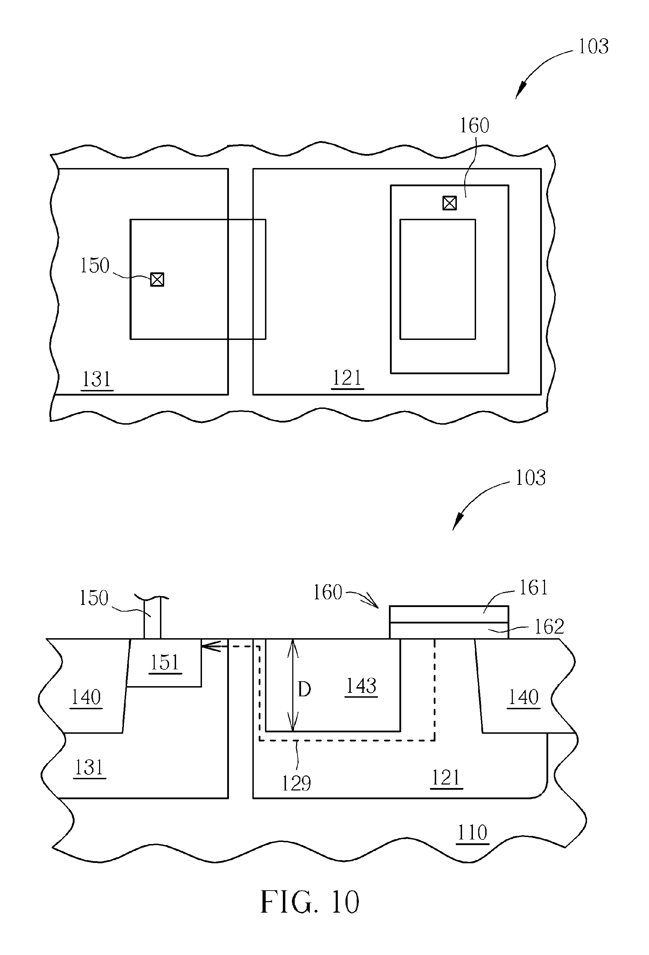

In another embodiment of the present invention, as shown in FIG. 9, the second doping well 131 and the first doping well 121 are in direct contact with each other. Also, the contact 150 is in direct contact with the drain doping region 151 and the shallow trench isolation 143 is disposed inside of the first doping well 121 but outside of the second doping well 131. In still another embodiment of the present invention, as shown in FIG. 10, the second doping well 131 and the first doping well 121 are not in direct contact with each other. Still, the contact 150 is in direct contact with the drain doping region 151 and similarly the shallow trench isolation 143 is disposed inside of the first doping well 121 but outside of the second doping well 131.

In either embodiment, the shallow trench isolation 143 is disposed inside the first doping well 121 to optionally adjust the electric resistance of the path 129. For example, the shallow trench isolation 143 may have an adjustable trench depth D such as 3000Å - 4000Å to adjust the programming voltage of the nonvolatile memory cell structure 103. The path 129may pass through the first doping well 121 alone, as shown in FIG. 7, pass through both the first doping well 121and the second doping well 131, as shown in FIG. 9, or pass through all the first doping well 121, the second doping well 131andthe substrate 110 together, as shown in FIG. 10, or the path 129 from the antifuse gate 160 to the drain doping region 151 travels around the shallow trench isolation 143.

The antifuse gate 160 is disposed on the first doping well 121 and includes a gate conductive layer 161 and a gate oxide layer 162. The gate conductive layer 161 is disposed on the gate oxide layer 162 and on the first doping well 121. The gate oxide layer 162is disposed between the gate conductive layer 161 and the first doping well 121. In other words, the gate oxide layer162 is in direct contact with the first doping well 121. Before programming, the gate conductive layer 161, the gate oxide layer 162and the first doping well 121 together serve as a capacitor. After programming, the gate oxide layer 162 is intentionally ruptured so the gate conductive layer 161, the gate oxide layer 162and the first doping well 121 together serve as a resistor. Preferably, the gate oxide layer 162 is thin enough to be easily ruptured by a predetermined programming voltage.

The contact 150 stays away from the antifuse gate 160 and is in direct contact with the drain doping region 151. In one embodiment of the present invention, there is a drain doping region 151, disposed in either the first doping well 121 or in the second doping well 131, and staying away from the antifuse gate 160 as shown in FIG. 7 to FIG. 10. The drain doping region 151 may have the same conductivity as the first doping well 121.

One feature of the nonvolatile memory cell structure 103of the present invention resides in that there is only one gate, namely the antifuse gate 160, disposed in the nonvolatile memory cell structure 103. In other words, there is no other gate, such as a select gate in the nonvolatile memory cell structure 103. Further, multiple nonvolatile memory cell structures of the present invention may form a memory cell array together. In such a way, a select gate is optionally needed to activate a designated memory cell in the memory cell array.

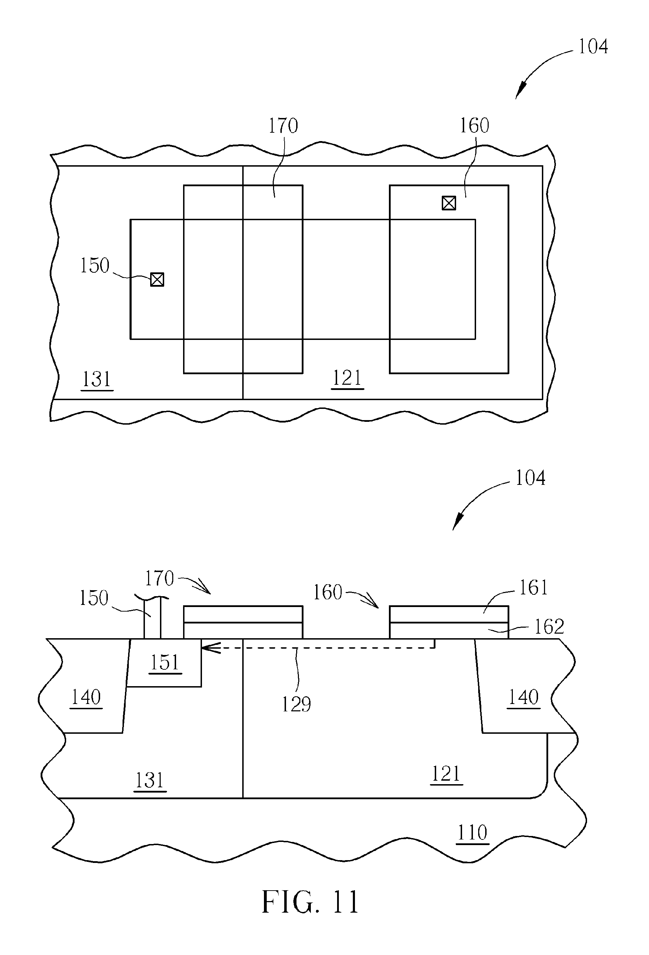

Next, please refer to FIG. 11 to FIG. 15, which illustrates examples of the nonvolatile memory cell structure. The nonvolatile memory cell structure 104of the present invention includes a substrate 110, a first doping well 121, an optional doping well, a shallow trench isolation 140, an optional shallow trench isolation 143, a contact 150, an optional drain doping region 151, the antifuse gate 160 as well as a select gate 170. The substrate 110 may be a semiconductive material, such as Si. In addition, the substrate 110 may have a first conductivity, such as N type or P type, preferably P type.

The shallow trench isolation 140 at least surrounds the first doping well121 or further surrounds the optional second doping well 131 as well. The contact 150 may be electrically connected to an optional drain doping region 151. The first drain doping region 151 may have the same conductivity as the first doping well 121 and is disposed inside the second doping well 131. Further, the optional shallow trench isolation 143 may be either disposed inside the first doping well 121 or inside the second doping well 131.

As shown in FIG. 11, the second doping well 131 and the first doping well 121 are in direct contact with each other so the path 129may pass through both the first doping well 121 and the second doping well 131. FIGS. 4A and 4D illustrate only the drain doping region 151 is present. FIGS. 4B and 4C further illustrate both the drain doping region 151and the optional shallow trench isolation 143 are present.

In another embodiment of the present invention, the second doping well 131 and the first doping well 121 are segregated by the substrate 110 and not in direct contact with each other so the path 129may pass through the first doping well 121, the substrate 110 and the second doping well 131, as shown in FIGS. 4C or 4D.

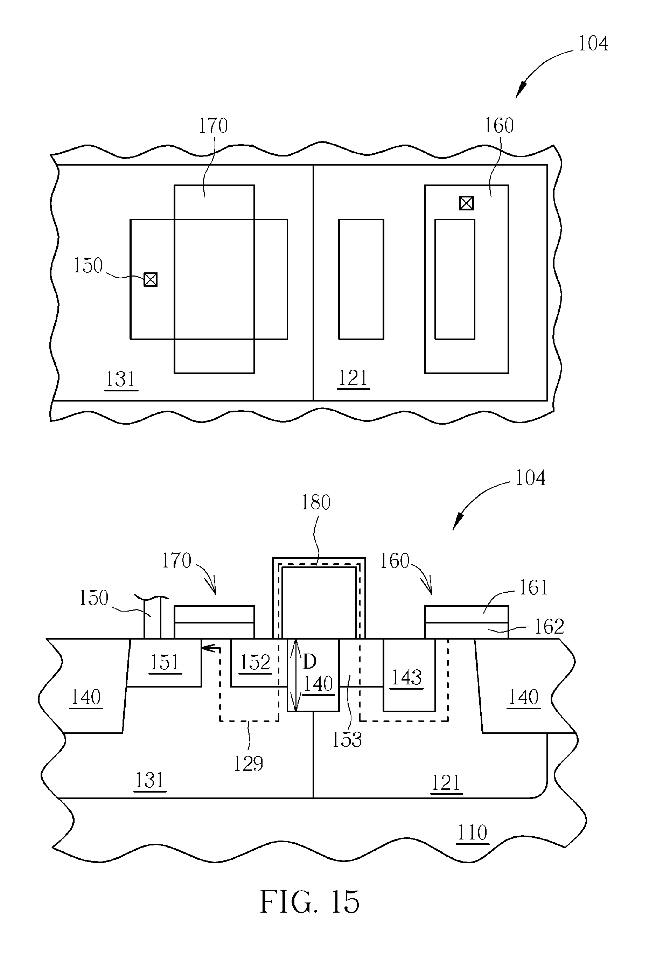

In still another embodiment of the present invention, there may be multiple drain doping regions. For example, as shown in FIG. 15, there are a second drain doping region 152 and a third drain doping region 153. The second drain doping region 152 is disposed inside the second doping well 131 and adjacent to the select gate 170. The third drain doping region 153 is disposed inside the first doping well 121 and adjacent to the antifuse gate 160 so that the shallow trench isolation 143 is sandwiched between the second drain doping region 152 and the third drain doping region 153. A metal routing 180 is used to electrically connect the second drain doping region 152 and the third drain doping region 153. The structure as shown in FIG. 15 is able to adjust the programming voltage by adjusting multiple dimensions, such as to adjust that of the first doping well 121, of the second doping well 131,of the drain doping region 151, of the second drain doping region 152 and/or of the third drain doping region 153.

In some embodiments, the shallow trench isolation 143 is disposed inside the first doping well 121 to adjust the resistance of the path 129. As shown in FIG. 15, the shallow trench isolation 143 is disposed between the first doping well 121/the second doping well 131 or the second drain doping region 152/the third drain doping region 153 as well. For example, the shallow trench isolation 143 may have an adjustable trench depth D such as 3000Å - 4000Å to optionally adjust the programming voltage of the nonvolatile memory cell structure 103.

The antifuse gate 160 is disposed on the first doping well 121 and includes a gate conductive layer 161 and a gate oxide layer 162. The gate conductive layer 161 is disposed on the gate oxide layer 162 and on the first doping well 121. The gate oxide layer 162is disposed between the gate conductive layer 161 and the first doping well 121. In other words, the gate oxide layer162 is in direct contact with the first doping well 121. The contact 150 stays away from the antifuse gate 160.

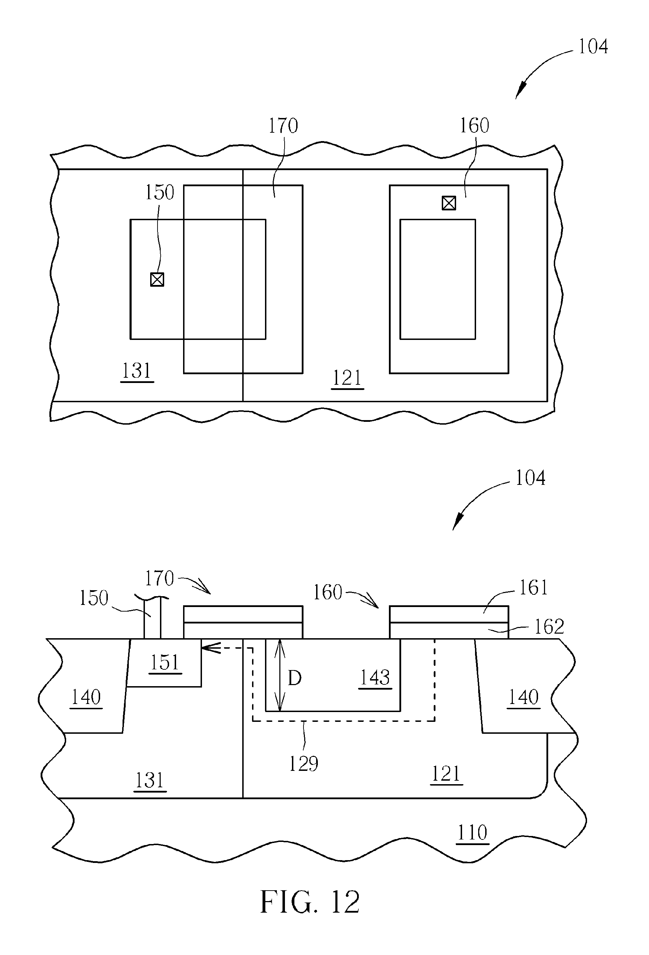

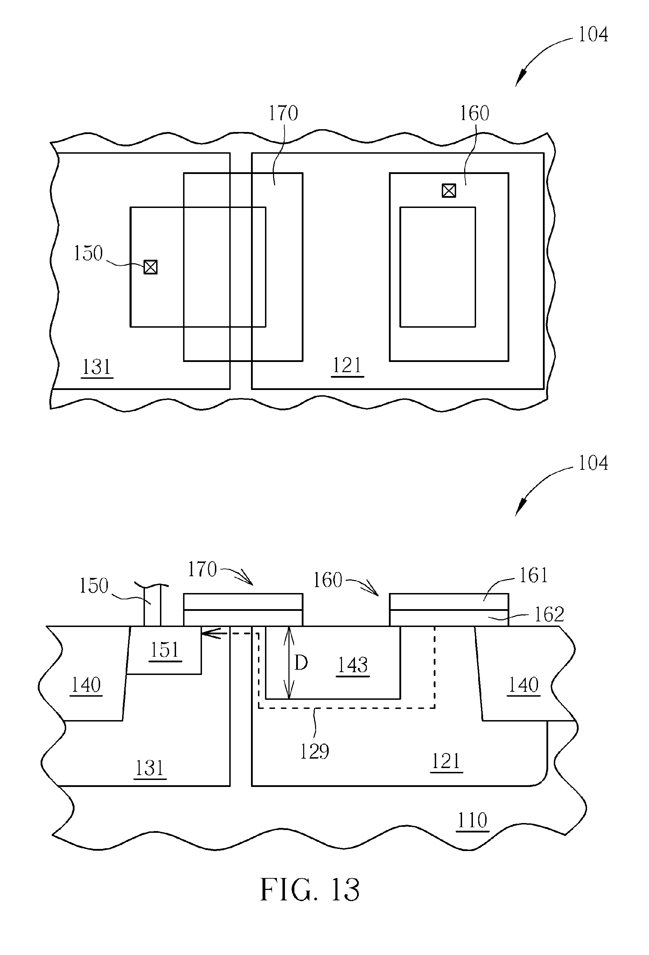

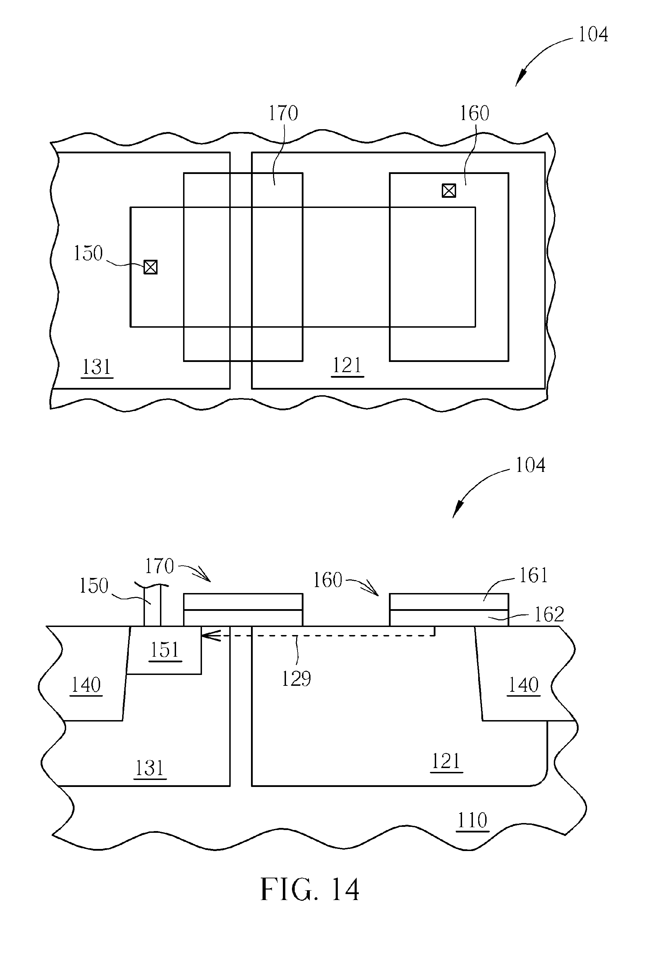

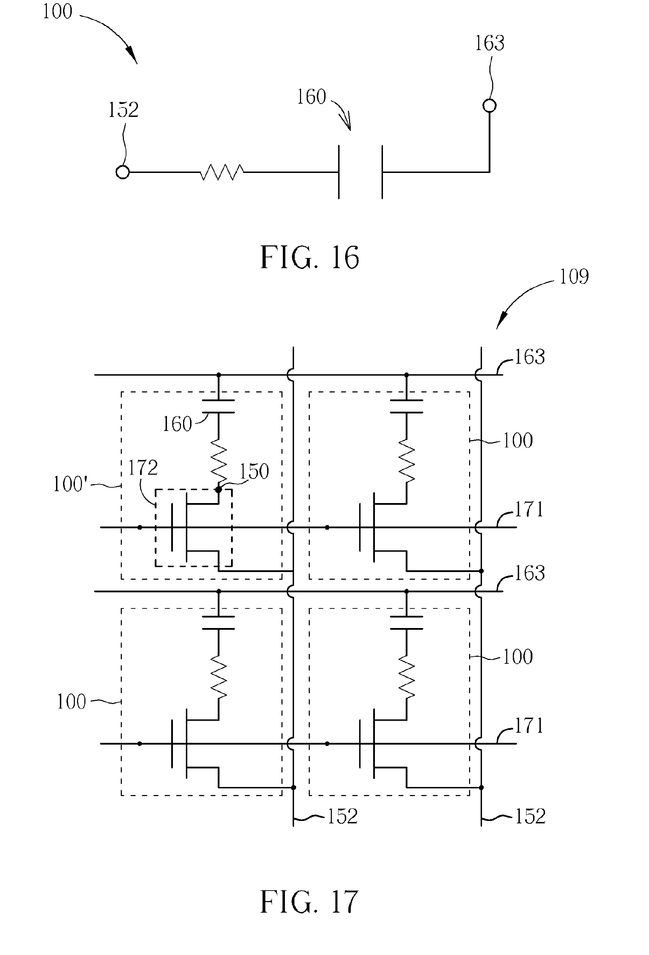

Before programming, the gate conductive layer 161, the gate oxide layer 162 and the first doping well 121 together serve as a capacitor. After programming, the gate oxide layer 162 is intentionally ruptured so the gate conductive layer 161, the gate oxide layer 162 and the first doping well 121 together serve as a resistor. Preferably, the gate oxide layer 162 is thin enough to be easily ruptured by a predetermined programming voltage. Further, there is an additional select gate 170 to control the activation of the nonvolatile memory cell structure 104. The select gate 170 may be disposed on the second doping well 131 alone, as shown in FIG. 15, or disposed on both the first doping well 121 and the second doping well 131, as shown in FIG. 11 or FIG. 12, or disposed on the first doping well 121, the second doping well 131 and the substrate 110, as shown in FIG. 13 or FIG. 14. A select transistor 172 includes a select gate 170 and the corresponding doping wells or doping regions. The select transistor 172 is a MOS device, such as a laterally diffused metal oxide semiconductor (LDMOS) or a double-diffused MOS (DMOS) for example. In the light of the above various nonvolatile memory cells, the present invention in another aspect also provides a method for programming a nonvolatile memory cell. First, as shown in FIG. 16 or FIG. 17, at least one nonvolatile memory cell 100 is provided. At least one nonvolatile memory cell may be a single nonvolatile memory cell, as shown in FIG. 16, or in a form of an array 109, as shown in FIG. 17. When the nonvolatile memory cell is a single nonvolatile memory cell, the antifuse gate 160 is electrically connected to an antifuse line 163 and the contact 150 is electrically connected to a bit line 152. When the nonvolatile memory cells form an array, the contact 150 of a nonvolatile memory cell 100 is connected to a select transistor 172 which connected to a word line 171 to select a specific nonvolatile memory cell 100' in the array 109. And the select transistor 172 is further connected to the bit line 152. Please refer to the above descriptions for the detail structures of the nonvolatile memory cells.

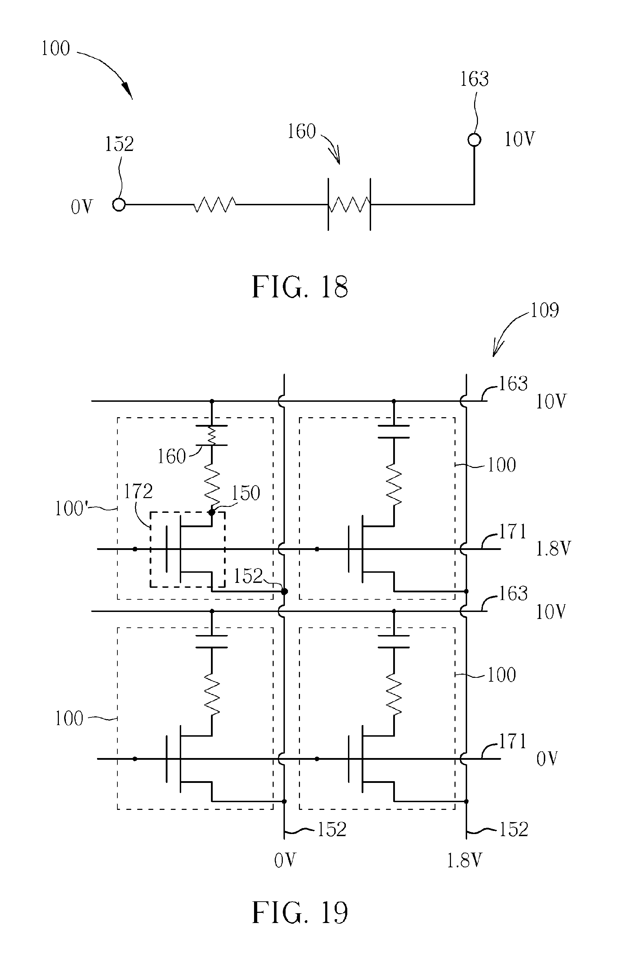

Next, the bit line 152 is grounded and the antifuse line 163 is provided with a programming voltage which is sufficiently high to physically convert the capacitor (to rupture the capacitor) to a resistor. When the nonvolatile memory cell is a single nonvolatile memory cell, as shown in FIG. 18, the antifuse line 163 is given a programming voltage, such as low as 10V, and the bit line 152 is grounded. The capacitor is accordingly ruptured due to 10V bias. When the nonvolatile memory cells form an array, as shown in FIG. 19, similarly the antifuse line 163 is given a programming voltage, such as low as 10V, and at least one of the bit line 152 is grounded. One of the word line 171 is given an activating voltage to select a line of specific nonvolatile memory cells (such as the nonvolatile memory cell 100') in the array 109 and the others which are not selected remains inactivated. The activating voltage may be as low as 1.8V. The result is that only one specific nonvolatile memory cell 100' is programmed in the array 109. It is also possible that the antifuse line 163 is grounded, and the bit line 152 is given a programming voltage, such as low as 10V.

Please note that in view of the above steps, the antifuse line 163 may be always given a programming voltage regardless how and where. This means that the antifuse line 163 does not need decoding, which is one of the features of the method of the present invention. Moreover, there are only two different voltages, namely the programming voltage and the activating voltage, are required in the steps to simplify the design of the circuit. If the select gate is absent, the activating voltage is not needed. This is another of the features of the method of the present invention. Still, the programming voltage may be as low as 10V and the activating voltage may be as low as 1.8V to save energy and power, which is still another of the features of the method of the present invention. Further, the bit line 152 and the word line 171 are designed to easily switch between the activating voltage/grounded to reach a simpler circuit design.

In another aspect, the present invention also provides a method for reading a nonvolatile memory cell. First, as shown in FIG 7A or 7B, at least one nonvolatile memory cell 100 is provided. At least one nonvolatile memory cell 100 may have been programmed, such as the nonvolatile memory cell 100'. At least one nonvolatile memory cell 100 may be a single nonvolatile memory cell 100, as shown in FIG. 16, or in a form of an array 109, as shown in FIG. 17. When the nonvolatile memory cell is a single nonvolatile memory cell, the antifuse gate 160 is electrically connected to an antifuse line 163 and the contact 150 is electrically connected to a bit line 152. When the nonvolatile memory cells form an array 109, similarly the antifuse gate 160 is electrically connected to an antifuse line 163 and the contact 150 of a nonvolatile memory cell 100 is connected to a select transistor 172 which connected to a bit line 152. The select gate 170 is further electrically connected to a word line 171 to select a specific nonvolatile memory cell in the array 109. And the select transistor 172 is further connected to the bit line 152. Please refer to the above descriptions for the detail structures of the nonvolatile memory cells.

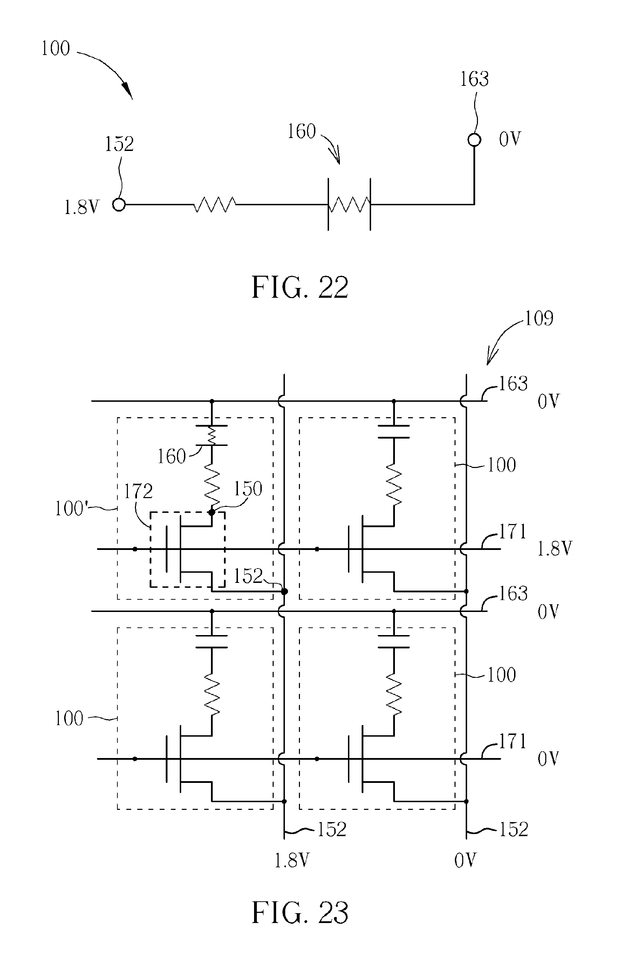

Next, the antifuse line 163 is optionally grounded and the bit line 152 is provided with a reading voltage, which may be the same as the activating voltage, to read the nonvolatile memory cell 100 or the array 109. When the nonvolatile memory cell is a single nonvolatile memory cell, as shown in FIG. 22, the bit line 152 is given a reading voltage, such as low as 1.8V, and the antifuse line 163 is grounded. The small reading voltage is sufficient to determine if the memory cell 100 is in a state of a capacitor or a resistor.

When the nonvolatile memory cells form an array, as shown in FIG. 23, similarly the bit line 152 is given a reading voltage, such as low as 1.8V, and at least one of antifuse line 163 is grounded. One of the word line 171 is given an activating voltage to select a line of specific nonvolatile memory cells in the array 109 and the others which are not selected remains inactivated. The activating voltage may be the same as the reading voltage and as low as 1.8V. The result is that only one specific nonvolatile memory cell 100' is read in the array 109. It is also possible that the bit line 152 is grounded, and the antifuse line 163 is given the reading voltage, such as low as 1.8V.

Please note that in view of the above steps, the antifuse line 163 may be always given grounded regardless how and where. This means that the antifuse line 163 does not need decoding, which is one of the features of the method of the present invention. Moreover, there are only two different voltages, namely the reading voltage / the activating voltage and grounded, are required in the reading steps to simplify the design of the circuit, which is another of the features of the method of the present invention. Still, the reading voltage as well as the activating voltage may be as low as 1.8V to save energy and power, which is still another of the features of the method of the present invention. Further, the bit line 152 and the word line 171 may be designed to easily switch between the reading voltage/the activating voltage and grounded to reach a simpler circuit design. For example, when the word line and the bit line are provided with the same voltage at the same time, at least one of the nonvolatile memory cells is read.

## Claims

1. A nonvolatile memory cell structure (102, 103, 104), **characterized by**:
a substrate (110) of a first conductivity;
a first doping well (121) of a second conductivity disposed in said substrate (110);
a second doping well (131) of said first conductivity disposed in said substrate (110);
an antifuse gate (160) disposed on said first doping well (121) and comprising:
a gate conductive layer (161) disposed on said first doping well (121); and
a gate oxide layer (162)disposed between said gate conductive layer (161) and said first doping well (121) and directly contacting said first doping well (121); and
a drain doping region (151) away from said antifuse gate (160), wherein a current path (129) from said antifuse gate (160) to said drain doping region (151) travels through said first doping well (121) and said second doping well (131).

2. The nonvolatile memory cell structure (102, 103, 104) of claim 1, further **characterized in that** said first doping well (121) is in direct contact with said second doping well (131).

3. The nonvolatile memory cell structure (104) of claim 1 or 2, further **characterized by** a select gate (170) disposed on both said first doping well (121) and said second doping well (131).

4. The nonvolatile memory cell structure (104) of any of claims 1-3, further **characterized by**:
a select gate (170) disposed on said second doping well (131);
a first drain doping region (151) disposed inside said second doping well (131);
a second drain doping region (152) disposed inside said second doping well (131) and adjacent to said select gate (170);
a third drain doping region (153) disposed inside said first doping well (121) and adjacent to said antifuse gate (160);
a shallow trench isolation (143) disposed between said second drain doping region (151) and said third drain doping region (153); and
a metal routing (180) to electrically connect said second drain doping region (152) and said third drain doping region (153).

5. The nonvolatile memory cell structure (104) of claim 4, further **characterized in that** said shallow trench isolation (143) has an adjustable trench depth.

6. The nonvolatile memory cell structure (102) of claim 1, further **characterized in that** said first doping well (121) is segregated from said second doping well (131) by a predetermined length and the current path (129) travels further through said substrate (110).

7. The nonvolatile memory cell structure (103) of claim 1 further **characterized by** a shallow trench isolation (143) disposed inside said first doping well (121) as well as between said antifuse gate (160) and said second doping well (131), wherein said current path (129) further travels around said shallow trench isolation (140).

8. The nonvolatile memory cell structure (102, 103, 104) of any of claims 1-7, further **characterized in that** said drain doping region (151, 152) disposed inside said second doping well (131).

9. The nonvolatile memory cell structure (102, 104) of any of claims 1-8, further **characterized in that** said antifuse gate (160) serves as either a capacitor or a resistor.

10. A symmetric nonvolatile memory cell structure (101), **characterized by**:
a substrate (110) of a conductivity;
a doping well (120) disposed in said substrate (110);
a shallow trench isolation set comprising a left shallow trench isolation (141) and a right shallow trench isolation (142) which are symmetrically disposed inside said doping well (120);
drain doping regions comprising a left drain doping region (151) and a right drain doping region (152) and disposed symmetrically inside said doping well (120), wherein said left drain doping region (151) is disposed adjacent to said left shallow trench isolation (141) and said right drain doping region (152) is disposed adjacent to said right shallow trench isolation (142); and
an antifuse gate (160) disposed on said doping well (120), between said symmetric shallow trench isolation set and comprising:
a gate conductive layer (161) disposed on said doping well (120); and
a gate oxide layer (162) disposed between said gate conductive layer (161) and said doping well (120) and directly contacting said doping well (120).

11. The symmetric nonvolatile memory cell structure (101) of claim 10, further **characterized in that** said doping well (120) is of conductivity different from the conductivity of said substrate (110).

12. The symmetric nonvolatile memory cell structure (101) of claim 10 or 11, further **characterized by** a further doping well (130) of a conductivity different from the conductivity of said substrate (110), the further doping well (130) entirely surrounding said doping well (120) and being disposed between said substrate (110) and said doping well (121), wherein said doping well (120) has a conductivity different from the conductivity of the further doping well (130).

13. A nonvolatile memory cell structure (103), **characterized by**:
a substrate (110) of a first conductivity;
a first doping well (121) of a second conductivity disposed in said substrate (110);
anantifusegate (160) disposed on said first doping well (121) and comprising:
a gate conductive layer (161) disposed on said first doping well (121); and
a gate oxide layer (162) disposed between said gate conductive layer (161) and said first doping well (121) and directly contacting said first doping well (121);
a drain doping region (151) disposed inside said first doping well (121) and away from said antifuse gate (160); and
a shallow trench isolation (143) disposed between said drain doping region (151) and said antifuse gate (160), wherein a current path (129) from said antifuse gate (160) to said drain doping region (151) travels through around said shallow trench isolation (143).

14. The nonvolatile memory cell structure (103) of claim 13, further **characterized in that** said shallow trench isolation (143) has an adjustable trench depth.

15. A method for reading a nonvolatile memory cell (102, 104), **characterized by**:
providing at least one nonvolatile memory cell (102, 104) of claim 1, wherein said antifuse gate (160) is electrically connected to an antifuse line (163), and said drain doping region (151) is electrically connected to a bit line (152); and
grounding said antifuse line (163) and providing said bit line (152) with a reading voltage to read said nonvolatile memory cell (102, 104).

16. A method for reading a nonvolatile memory cell (101), **characterized by**:
providing at least one nonvolatile memory cell (101) of claim 10, wherein said antifuse gate (160) is electrically connected to an antifuse line (163), and said drain doping region is electrically connected to a bit line (152); and
grounding said antifuse line (163) and providing said bit line (152) with a reading voltage to read said nonvolatile memory cell (101).

17. A method for reading a nonvolatile memory cell (103), **characterized by**:
providing at least one nonvolatile memory cell (103) of claim 13, wherein said antifuse gate (160) is electrically connected to an antifuse line (163), and said drain doping region (151) is electrically connected to a bit line (152); and
grounding said antifuse line (163) and providing said bit line (152) with a reading voltage to read said nonvolatile memory cell (103).
